# EUROPEAN PATENT APPLICATION

(11) **EP 3 937 208 A1**
(43) Date of publication of application: **12.01.2022**
(21) Application number: 21183485.8
(22) Date of filing: 02.07.2021
(51) Int. Cl.: H01L 21/02, H01L 21/205

(54) **METHOD FOR MANUFACTURING MONOCRYSTALLINE SUBSTRATE**

(30) Priority: 09.07.2020 KR 20200084854
(71) Applicant: Lumigntech Co., Ltd., Gyeonggi-Do 14322 (KR)
(72) Inventor: LEE, Hae Yong, 14306 Gwangmyeong-Si, Gyeonggi-Do (KR); CHOI, Young Jun, 06715 Seoul (KR); OH, Hae Gon, 14305 Gwangmyeong-Si, Gyeonggi-Do (KR)
(74) Representative: Michalski Hüttermann & Partner Patentanwälte mbB

(57) **Abstract**

Provided is a method for manufacturing a monocrystalline substrate, the method including: a process of forming a seed layer on a base charged into a monocrystalline growth apparatus; a process of taking the base, on which the seed layer is formed, out of the monocrystalline growth apparatus and irradiating laser onto the seed layer from a lower side of the base to form a separation layer having a plurality of voids; a process of charging the base, on which the separation layer is formed, into the monocrystalline growth apparatus to form a monocrystalline layer on the separation layer; and a separation process of taking the base, on which the separation layer and the monocrystalline layer are formed, out of the monocrystalline growth apparatus to separate the monocrystalline layer from the base. Therefore, the monocrystalline layer may be grown on the flat surface of the separation layer, and the monocrystalline substrate having the excellent crystallinity and suppressed in occurrence of the defects may be prepared. That is, the monocrystalline substrate having the excellent crystallinity and suppressed in occurrence of the defects while omitting the planarization process for planarizing the surface of the flat separation layer may be prepared.

## Description

### CROSS-REFERENCE TO RELATED APPLICATION

This application claims priority to Korean Patent Application No. 10-2020-0084854 filed on July 9, 2020 and all the benefits accruing therefrom under 35 U.S.C. §119, the contents of which are incorporated by reference in their entirety.

### BACKGROUND

The present disclosure relates to a method for manufacturing a monocrystalline substrate, and more particularly, to a method for manufacturing a monocrystalline substrate, which is capable of suppressing or preventing an occurrence of defects of a monocrystalline layer.

A GaN monocrystalline substrate is manufactured by growing a GaN monocrystalline layer on a sapphire substrate and then separating the GaN monocrystalline layer from the sapphire substrate. Here, the GaN monocrystalline layer separated from the sapphire substrate is generally referred to as a GaN monocrystalline substrate.

As a method for separating the GaN monocrystalline layer from the sapphire substrate, there is a method for naturally separating the GaN monocrystalline layer through a cooling process. The method for the natural separation through the cooling process is a method for forming a weak layer having a plurality of voids between a sapphire substrate and a GaN monocrystalline layer to separate the GaN monocrystalline layer by using the weak layer. That is, when the weak layer having the plurality of voids and the GaN monocrystalline layer are laminated on the sapphire substrate and then cooled, stress is generated in the weak layer due to a difference in thermal expansion coefficient between the sapphire substrate and the GaN monocrystalline layer. Here, the weak layer is separated or divided in a lamination direction of the sapphire substrate and the GaN monocrystalline layer to separate the GaN monocrystalline layer from the sapphire substrate.

In preparing the weak layer having the plurality of voids, according to the related art, a thin film is formed on the sapphire substrate, and then, a portion of the thin film is removed by a chemical etching method. In addition, as another method, after forming a first thin film on the sapphire substrate, a method for selectively forming a second thin film on the first thin film is prepared. These methods are performed so that the void is disposed at a center of a thickness direction of the weak layer. Thus, the top surface of the weak layer, on which the GaN monocrystalline layer is to be formed, is not formed to be flat due to the voids.

In addition, when GaN is grown on the weak layer that is not flat, crystallinity may be poor, and thus a poor substrate may be manufactured. Thus, a process for planarizing the top surface of the non-flat week layer, for example, an epitaxial lateral growth (ELG) process is additionally performed. However, there is a limitation in that the process is complicated, and a process time increases as the planarization process is accompanied after the formation of the weak layer.

(Prior Art Document) Korean Patent Registration No. 1379290

### SUMMARY

The present disclosure provide a method for manufacturing a monocrystalline substrate, which is capable of suppressing or preventing an occurrence of defects of a monocrystalline layer when the monocrystalline substrate is manufactured by separating the monocrystalline layer from a base.

The present disclosure also provide a method for manufacturing a monocrystalline substrate, which is capable of reducing a manufacturing time when the monocrystalline substrate is manufactured by separating a monocrystalline layer from a base.

In accordance with an exemplary embodiment, a method for manufacturing a monocrystalline substrate includes: a process of forming a seed layer on a base charged into a monocrystalline growth apparatus; a process of taking the base, on which the seed layer is formed, out of the monocrystalline growth apparatus and irradiating laser onto the seed layer from a lower side of the base to form a separation layer having a plurality of voids; a process of charging the base, on which the separation layer is formed, into the monocrystalline growth apparatus to form a monocrystalline layer on the separation layer; and a separation process of taking the base, on which the separation layer and the monocrystalline layer are formed, out of the monocrystalline growth apparatus to separate the monocrystalline layer from the base.

In the process of forming the separation layer, the voids may be formed in an interface between the base and the separation layer.

The process of irradiating the laser onto the seed layer from the lower side of the base may include a process of discontinuously irradiating the laser in an extension direction of the seed layer.

The process of discontinuously irradiating the laser in the extension direction of the seed layer may include: a process of preparing a mask, in which a plurality of opening and closed portions are alternately disposed; a process of disposing the mask to face the base at an opposite side of the seed layer; and a process of emitting the laser to pass through the mask and the base.

In the process of preparing the mask, a ratio of a length of each of the openings to a length of each of the closed portions may be 2:1 to 1:5.

In the process of preparing the mask, the opening may have a length of approximately 1 *µ*m to approximately 100 *µ*m.

The process of discontinuously irradiating the laser in the extension direction of the seed layer may include: a process of horizontally moving the base, on which the seed layer is formed; and process of irradiating the laser onto the base from an opposite side of the seed layer formed on the base which moves horizontally and alternately repeatedly performing an stopping operation of the irradiation.

The separation process may include a process of dividing the separation layer in a lamination direction of the base and the monocrystalline layer.

Each of the seed layer and the monocrystalline layer may include a GaN layer.

In the process of forming the seed layer, the seed layer may be formed to a thickness of approximately 2 *µ*m to approximately 30 *µ*m.

### BRIEF DESCRIPTION OF THE DRAWINGS

Exemplary embodiments can be understood in more detail from the following description taken in conjunction with the accompanying drawings, in which:
FIG. 1 is a flowchart illustrating a method for manufacturing a monocrystalline substrate in accordance with an exemplary embodiment;
FIG. 2 is a conceptual view sequentially illustrating the method for manufacturing the monocrystalline substrate in accordance with an exemplary embodiment;
FIG. 3 is a view for explaining a mask in accordance with an exemplary embodiment; and
FIG. 4 is a photograph obtained by photographing a portion of a separation layer, in which a void is formed, through the method in accordance with an exemplary embodiment.

### DETAILED DESCRIPTION OF EMBODIMENTS

Hereinafter, specific embodiments will be described in more detail with reference to the accompanying drawings. The present invention may, however, be embodied in different forms and should not be construed as limited to the embodiments set forth herein. Rather, these embodiments are provided so that this disclosure will be thorough and complete, and will fully convey the scope of the present invention to those skilled in the art. In the figures, the dimensions of layers and regions are exaggerated for clarity of illustration. Like reference numerals refer to like elements throughout.

The present disclosure relates to a method for manufacturing a monocrystalline substrate, which is capable of suppressing or preventing an occurrence of defects of a monocrystalline layer when the monocrystalline substrate is manufactured by separating the monocrystalline layer from a base. In addition, the present disclosure relates to a method for manufacturing a monocrystalline substrate, which is capable of reducing a time taken to manufacture the monocrystalline substrate.

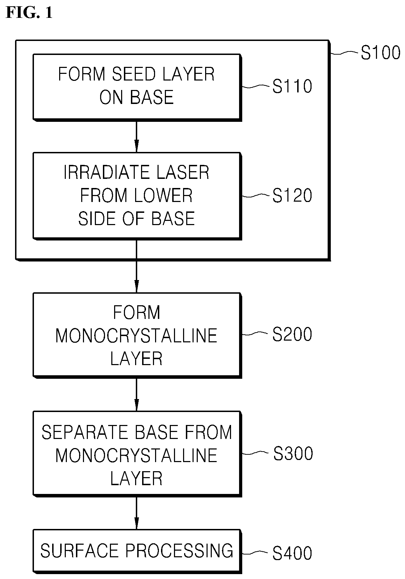

Hereinafter, a method of manufacturing a monocrystalline substrate in accordance with an exemplary embodiment will be described with reference to FIGS. 1 to 3.

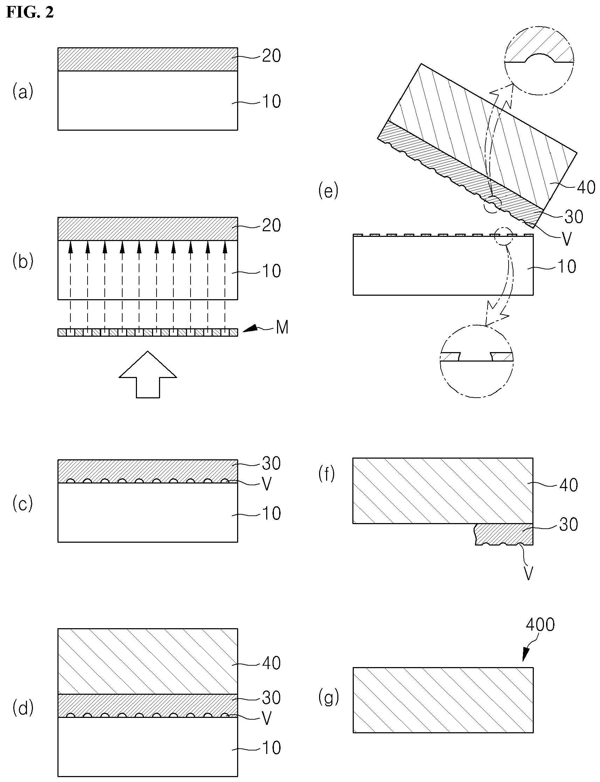

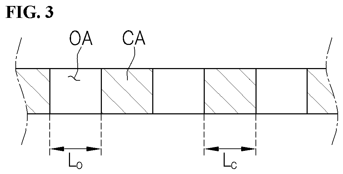

FIG. 1 is a flowchart illustrating a method for manufacturing a monocrystalline substrate in accordance with an exemplary embodiment. FIG. 2 is a conceptual view sequentially illustrating the method for manufacturing the monocrystalline substrate in accordance with an exemplary embodiment. FIG. 3 is a view for explaining a mask in accordance with an exemplary embodiment.

Referring to FIGS. 1 and 2, a method of manufacturing a monocrystalline substrate in accordance with an exemplary embodiment includes a process (S100) of forming a separation layer 30 having a plurality of voids V on a prepared base 10, a process (S200) of forming a monocrystalline layer 40 on the separation layer 30, a process (S300) of cooling the base 10, on which the monocrystalline layer 40 is formed, to separate the monocrystalline layer 40 from the base 10, and a process (S400) of processing a surface of the monocrystalline layer 40.

Here, the monocrystalline layer 40 separated from the base 10 or the monocrystalline layer 40 on which the surface processing is completed is generally referred to as the monocrystalline substrate 400.

Referring to FIG. 2, the base 10 may have a plate shape having a predetermined area on which a thin film is capable of being formed. Also, the base 10 may be a substrate made of a material capable of transmitting laser light (hereinafter, referred to as laser). As a specific example, a substrate through which the laser having a wavelength of approximately 362 nm or less is capable of being transmitted may be used as the base 10. As a more specific example, a substrate through which any one of laser having a wavelength of approximately 355 nm, laser having a wavelength of approximately 266 nm, XeCl excimer laser having a wavelength of approximately 308 nm, KrF excimer laser having a wavelength of approximately 248 nm, and ArF excimer laser having a wavelength of approximately 193 nm is capable of be transmitted, among solid lasers, may be preferably used, for example, a sapphire substrate may be used. Here, the sapphire substrate may be a sapphire wafer.

When the base 10 is provided, the separation layer 30 is formed on the base 10 (S100). For this, first, a seed layer 20 is formed on the base 10 as illustrated in (a) of FIG. 2 (S110). The seed layer 20 may be made of the same material as the monocrystalline layer 40 to be formed later and may be formed as a GaN layer. The seed layer 20 may be formed to a thickness of several µm to several tens of µm, preferably approximately 2 µm to approximately 30 µm, and more preferably, approximately 5 µm to approximately 20 µm.

When the seed layer 20 has a thickness less than approximately 2 µm, the seed layer 20 may be separated, for example, be peeled off from the base 10 in the process of irradiating the laser onto the seed layer 20 to form the voids V later. Also, if the thickness of the seed layer 20 exceeds approximately 30 µm, when the laser is irradiated onto the seed layer 20 to form the voids V, large stress is applied to the seed layer 20. In this case, when the monocrystalline layer 40 is grown on the seed layer 20, in which the voids V are formed, that is, the separation layer 30, a growth failure such as the peeling-off of at least a portion of the monocrystalline layer 40 from the separation layer 30 during the growth of the monocrystalline layer 40 may occur.

The seed layer 20 may be formed by growing a GaN layer on the base 10 in a monocrystalline growth apparatus. Also, the monocrystalline growth apparatus may be, for example, an apparatus for growing the GaN layer through a hydride vapor phase epitaxial (HVPE) method. A method for forming the seed layer 20 of the GaN layer by the HVPE method will be briefly described as follows.

First, the base 10 is charged into a reaction space, i.e., a furnace of the monocrystalline growth apparatus, and a Ga source material and an HCl gas are supplied into the furnace. Then, a GaCl gas is generated by a reaction between the Ga source material and the HCl gas. Then, when an NH₃ gas is supplied, the GaN layer is formed by a reaction between GaCl and NH₃.

Reaction formula 1) Ga + HCl(g) -> GaCl(g) + 1/2 H₂ (g)

Reaction formula 1) GaCl(g) + NH₃ -> GaN(s) + HCl(g) + H₂ (g)

Here, it is preferable to adjust a temperature in the furnace to approximately 950°C to approximately 1,050°C.

When the temperature in the furnace is less than approximately 950° C, the crystallinity of the seed layer 20 may be deteriorated. In addition, when the monocrystalline layer 40 is formed on the separation layer 30 formed by irradiating the laser onto the seed layer 20 having low crystallinity, defects may occur in the monocrystalline layer 40. On the other hand, when the temperature in the furnace exceeds approximately 1,050°C, a growth rate of the seed layer 20 is slow, and the stress in the seed layer 20 increases. Thus, while the seed layer 20 is grown on the base 10, the seed layer 20 may be separated from the base 10, that is, be peeled off.

The method for forming the seed layer 20 is not limited to the HVPE method, and various methods such as chemical vapor deposition (CVD), metal organic chemical vapor deposition (MOCVD), etc. may be used.

When the seed layer 20 is formed on the base 10, the separation layer 30 is formed by irradiating the laser onto the seed layer 20 (S120). That is, the separation layer 30 is formed as the seed layer 20. For this, first, the base 10 on which the seed layer 20 is formed is carried out of the monocrystalline growth apparatus.

Then, the laser is irradiated onto the seed layer 20. For this, for example, the base 10 on which the seed layer 20 is formed is supported on a stage facing a laser irradiation device for irradiating the laser. Then, as illustrated in (b) of FIG. 2, a mask M having a plurality of holes (hereinafter, referred to as openings OA) are disposed below the base 10. Accordingly, the laser passing through the openings OA of the mask M is irradiated onto the seed layer 20 after passing through the base 10. Here, since a GaN energy band gap is approximately 3.425 eV, and an absorption wavelength is approximately 362 nm, it is preferable to use a laser having a wavelength of approximately 362 nm or less. As the laser irradiated onto the seed layer, any one of laser (3.5eV) having a wavelength of approximately 355 nm, laser (4.68eV) having a wavelength of approximately 266 nm, XeCl excimer laser (4.04eV) having a wavelength of approximately 308 nm, KrF excimer laser (5.02eV) having a wavelength of approximately 248 nm, and ArF excimer laser (6.45eV) having a wavelength of approximately 193 nm among solid lasers may be preferably used.

The laser emitted from a lower side of the base 10 passes through the plurality of openings OA provided in the mask M as described above and then passes through the base 10 and is irradiated onto the seed layer 20. In other words, that the laser is irradiated to pass through the plurality of openings OA provided to be spaced apart from each other may be described as that the laser is discontinuously irradiated in an extension direction of the base 10 or the seed layer 20. The laser irradiated onto the seed layer 20 melts at least a portion of the seed layer 20. Here, since the laser is irradiated onto the seed layer 20 through the plurality of openings OA provided in the mask M, an area of the seed layer 20 facing the plurality of openings OA of the mask M may be melted. That is, the seed layer 20 may be selectively or discontinuously melted by the mask M.

Also, a plurality of voids V, which are a plurality of empty spaces, are formed in the seed layer 20 by the selective melting of the seed layer 20 by the laser. That is, the area facing the plurality of openings OA of the mask M among the seed layer 20 made of GaN may be melted by the laser, and the voids V may be formed in the area. That is, the plurality of voids V may be discontinuously formed. In addition, the voids V are formed in an interface between the base 10 within the seed layer 20 and the seed layer 20 as illustrated in (c) of FIG. 2. In other words, each of the voids V is formed to have a predetermined height from the interface between the seed layer 20 and the base 10 in a direction opposite to the interface. Also, since the voids V are formed in the interface between the seed layer 20 and the base 10 as described above, it may be described as being formed to be more adjacent to the base 10 than the monocrystalline layer 40 to be formed on the separation layer 30 later. In addition, since the seed layer 20 in which the voids V are formed is referred to as the separation layer 300, the voids V may be described as being formed in an interface between the base 10 and the separation layer 30.

The voids V are formed in the interface between the base 10 and the separation layer 30 and have various shape. That is, the shape of each of the voids V may vary depending on an intensity of the irradiated laser, a moving speed of a stage on which the base 10 is seated, a thickness of the seed layer 20, and the like.

The seed layer 20 in which the plurality of voids V are formed, that is, the separation layer 30 is a layer formed to facilitate separation when the monocrystalline layer 40 is separated from the base 10 after the monocrystalline layer 40 is formed on the separation layer 30 and then cooled. That is, after the monocrystalline layer 40 is formed on the separation layer 30 and then cooled, stress is applied to the separation layer 30 between the base 10 and the monocrystalline layer 40 by a difference in thermal expansion coefficient between the monocrystalline layer 40 and the base 10. The stress may be applied in both directions of the base 10 and the monocrystalline layer 40 with respect to the separation layer 30, and thus, the separation layer 30 is separated or torn in an arrangement direction or lamination direction of the base layer 10 and the monocrystalline layer 40. As a result, the monocrystalline layer 40 is separated from the base 10, and the separation by the cooling is referred to as natural separation.

To divide the separation layer 30 in the arrangement direction of the base 10 and the monocrystalline layer 40 by the stress due to the difference in thermal expansion coefficient between the base 10 and the monocrystalline layer 40 during the cooling, the separation layer 30 needs to be weak. That is, due to the stress by the difference in the thermal expansion coefficient, the separation layer 30 needs to be week so that the separation layer 30 is easily divided, separated, or torn between the base 10 and the monocrystalline layer 40 in the arrangement direction or in a vertical direction.

Therefore, in this embodiment, the separation layer 30 is formed to have the plurality of voids V. When the plurality of pores V are provided in the separation layer 30, bonding force between the components constituting the separation layer 30 is weak compared to when the pores V are absent. In particular, the bonding force between the components is weak at a position at which the voids V are formed. Accordingly, when the monocrystalline layer 40 is formed on the separation layer 30 and then cooled, the separation layer 30 is easily separated in the lamination direction of the base 10 and the monocrystalline layer 40 by the stress due to the thermal expansion coefficient between the base 10 and the monocrystalline layer 40. As a result, the stress applied to the monocrystalline layer 40 during the cooling may be reduced, and thus, the defects in the monocrystalline layer 40 and the occurrence of the defects due to the stress may be reduced.

Also, as the voids V are formed in the interface between the base 10 and the separation layer 30, the monocrystalline layer 40 may be more easily separated from the base 10 during the cooling after forming the monocrystalline layer 40. That is, when the separation layer 30 is divided by the stress applied by the cooling, if the voids V are formed in the interface between the base 10 and the separation layer 30, the separation layer 30 may be separated with relatively small stress when compared to when the voids are formed in a center in a thickness direction of the separation layer 30. When compared to bonding force between layers made of the same material, bonding force between layers made of different materials may be relatively weak. In particular, bonding force at an interface between layers made of different materials or in an region adjacent to the interface may be weaker. In this embodiment, since the voids V are formed in the interface between the base 10 and the separation layer, which are made of different materials, the interface between the base 10 and the separation layer 30 may be more vulnerable to the stress. Thus, the stress applied to the monocrystalline layer 40 may be reduced.

Also, the separation layer 30 is divided with respect to the voids V, since the voids V are formed in the interface between the base 10 and the separation layer 30 so as to be disposed far from the monocrystalline layer 40, the stress applied to the monocrystalline layer 40 during the separation may be suppressed or minimized. As described above, the stress applied to the monocrystalline layer 40 may be reduced, and the occurrence of the defects in the monocrystalline layer 40 due to the stress may be suppressed or prevented.

Hereinafter, the process of irradiating the laser from the lower side of the base 10 will be described again.

As described above, when the seed layer 20 is formed on the base 10, the mask M is disposed under the base 10, and the laser is irradiated from the lower side of the mask M toward the base 10. The laser is irradiated onto the seed layer 20 after being transmitted through the base 10 by passing through the plurality of openings OA provided in the mask M. Thus, the plurality of voids V are formed in the seed layer 20.

As described above, the mask M is provided to include the plurality of openings OA through which the laser is capable of passing. In other words, as illustrated in FIG. 3, the mask M is provided to include the plurality of openings OA and a closed portion CA that is an area between the openings OA and is not opened. In addition, the opening OA and the closed portion CA are provided to be alternately disposed.

In this embodiment, a length ratio of the opening OA to the closed portion CA, i.e., 'length Lₒ of the opening:length L_{c} of the closed portion' is 2:1 to 1:5. That is, the length Lₒ of the opening OA may be smaller, the same, or greater than the length L_{c} of the closed portion CA. When the length Lₒ of the opening OA is less than the length L_{c} of the closed portion CA, the length Lₒ of the opening OA is approximately 0.2 or more and less than approximately 1 of the length L_{c} of the closed portion CA. In addition, when the length Lₒ of the opening OA is greater than the length L_{c} of the closed portion CA, the length Lₒ of the opening OA is greater than one time or less than twice the length L_{c} of the closed portion CA. Also, it is preferable that the length Lₒ of the opening OA is approximately 1 µm to approximately 100 µm.

When the length Lₒ of the opening OA is formed to be less than that of the closed portion CA, if the length Lₒ of the opening OA is formed to be less than approximately 0.2 of the length L_{c} of the closed portion CA, or the length Lₒ of the opening OA is less than approximately 1 µm, the separation layer 30 may not be divided in the arrangement direction of the base 10 and the monocrystalline layer 40 during the cooling. This may be because the length or area of the opening OA of the mask M is too small, and thus the size of each of the voids V formed in the separation layer 30 is too small. That is, it may be because the size of the void V is too small, and the separation layer 30 is strong against the stress due to the thermal expansion coefficient between the base 10 and the monocrystalline layer 40.

On the other hand, when the length of the opening OA is formed to be greater than that of the closed portion CA, if the length Lₒ of the opening OA is greater than twice the length L_{c} of the closed portion CA, or the length Lₒ of the opening OA exceeds approximately 100 µm, the seed layer 20 may be peeled off from the base 10 during the laser irradiation.

In the above description, the mask M is disposed under the base 10 on which the seed layer 20 is formed, and the laser is irradiated from the lower side of the mask M. However, this embodiment is not limited thereto, and the laser may be irradiated from an upper side of the base 10. That is, the mask M may be disposed between the laser irradiation device and the base 10 in a state in which the seed layer 20 is inverted to face the lower side, and the laser may be irradiated from the upper side of the mask M.

Also, in the above, it has been described that the separation layer 30 is formed by discontinuously irradiating the laser in the extension direction of the seed layer 20 using the mask M having the opening OA and the closed portion CA. However, the laser may be irradiated discontinuously in the extension direction of the seed layer 20 without using the mask M. That is, while the stage on which the base 10, on which the seed layer 20 is formed, is seated horizontally moves, the laser may be irradiated (or emitted) toward the seed layer 20 (turn-on), or stopping (turn-off) of the irradiation (or emission) may be alternately repeatedly performed several times to discontinuously irradiate the laser. Here, stopping the irradiation of the laser may mean that the laser is not emitted.

When the separation layer 30 is formed on the base 10, the monocrystalline layer 40 is formed on the separation layer 30 as illustrated in (d) of FIG. 2 (S200). In other words, a thin film, that is, a monocrystalline is grown using the separation layer 30 as a seed to grow the monocrystalline layer 40. For this, the base 10 on which the separation layer 30 is formed is charged into the monocrystalline growth apparatus, and the monocrystalline layer 40 is formed on the separation layer 30. Here, the monocrystalline layer 40 is made of the same material as the separation layer 30 or the seed layer 20 and may be made of, for example, GaN. Also, the monocrystalline layer 40 is formed to a thickness of several hundred µm to several thousand µm that is thicker than the separation layer 30 and is preferably formed to a thickness of approximately 400 µm or more. More preferably, it is formed to a thickness of approximately 400 µm to approximately 2,000 µm.

As described above, after the seed layer 20 is formed on the base 10, the voids V are formed in the interface between the base 10 and the seed layer 20 by irradiating the laser to the lower side of the base 10. Thus, the other surface of the separation layer 30, which is an opposite surface of one surface of the separation layer 30 that is in contact with the base 10 and on which the monocrystalline layer 40 is grown is formed to be flat. As a result, after forming the separation layer 30, there is no need to additionally perform a process of planarizing the other surface of the separation layer 30. Thus, the monocrystalline layer 40 having excellent crystallinity and suppressed defects while omitting the process of planarizing the separation layer 30 may be formed.

However, as in the method in accordance with the related art, a portion of the seed layer is removed by the chemical etching method, but when the separation layer is prepared by forming the voids in the seed layer through the selective growth method using a mask, the voids are disposed at the center in the thickness direction of the separation layer. In this case, since the other surface of the separation layer, on which the monocrystalline layer is to be grown, is not flat, there is a limitation in that a process for planarizing the other surface of the separation layer such as an epitaxial lateral growth (ELG) process has to be additionally performed. Thus, there is a limitation that the process is complicated, and the process time is long.

As described above, when the monocrystalline layer 40 is separated from the base 10, the separation layer 30 is separated so as to be divided in the thickness direction. Thus, the monocrystalline layer 40 and the base 10 are separated so that a portion of the separation layer 30 is attached to the monocrystalline layer 40, and the rest is attached to the base 10. When the monocrystalline layer 40 is separated from the base 10, there is need to polish the surface facing at least the base 10, i.e., one surface of the monocrystalline layer 40, to which the separation layer 30 is attached. When the surface processing is finished, the monocrystalline substrate 400, which is a final product, is prepared.

When one surface, i.e., a surface of the monocrystalline layer 40 is polished, the thickness of the monocrystalline layer 40 is reduced. To obtain the stable monocrystalline substrate 400, the thickness needs to be approximately 350 µm or more. However, when the thickness of the monocrystalline layer 40 formed on the separation layer 30 is less than approximately 400 µm, the thickness of the monocrystalline layer 40 after the surface processing may be less than approximately 350 µm. That is, an unstable monocrystalline substrate 400 having a thickness of less than approximately 350 µm may be manufactured. Therefore, in forming the monocrystalline layer 40 on the separation layer 30, the monocrystalline layer 40 is formed to have a thickness of approximately 400 µm or more.

The monocrystalline layer 40 may be formed in the same manner as the seed layer 20. That is, the Ga source material and the HCl gas are supplied into the reaction space in which the base 10, on which the separation layer 30 is formed, i.e., the furnace is charged. Thus, a GaCl gas is formed by the reaction between the Ga source material and the HCl gas, and then, the monocrystalline layer 40 made of GaN is formed by the reaction between the supplied NH₃ gas and GaCl.

When the formation of the monocrystalline layer 40 is finished, the base 10 is taken out from the monocrystalline growth apparatus. Also, the base 10 on which the separation layer 30 and the monocrystalline layer 40 are formed is taken out from the monocrystalline growth apparatus and cooled, preferably at room temperature.

When the base 10 on which the separation layer 30 and the monocrystalline layer 40 are formed is cooled, stress is applied to the separation layer 30 by the difference in thermal expansion coefficient between the base 10 and the monocrystalline layer 40. Here, the stress acts in a direction in which the thermal expansion coefficient is different, i.e., in the direction in which the base 10 and the monocrystalline layer 40 are arranged. That is, the stress is applied in both directions of the base 10 and the monocrystalline layer 40 with respect to the separation layer 30.

Thus, as illustrated in (e) of FIG. 2, a lower portion adjacent to the base 10 is separated to be divided toward the base 10 with respect to the thickness direction of the separation layer 30, and the rest is separated to be divided toward the monocrystalline layer 40. The separation occurs at a position in the separation layer 30, at which the plurality of voids V are formed. That is, a portion of the separation layer 30 is separated to be divided toward the base 10, and the rest is separated to be divided toward the monocrystalline layer 40 on the area in which the voids V are formed, based on the thickness direction of the separation layer 30. When described again based on one void V, the lower are that is close to the base 10 is separated to be divided toward the base 10, and the remaining region is separated to be divided toward the monocrystalline layer 40.

Thereafter, when a predetermined impact is applied to the monocrystalline layer 40 or the base 10, the monocrystalline layer 40 may be completely separated from the base 10. Of course, the monocrystalline layer 40 may be separated from the base 10 only by the cooling without applying the impact.

Next, one surface of the monocrystalline layer 40, to which a portion of the separation layer 30 is attached, is polished (see (f) of FIG. 2) to remove the separation layer 30 from the monocrystalline layer 40. In addition, an opposite surface of one surface of the monocrystalline layer 40, to which the separation layer 30 is attached, may also be polished. Here, the surface may be polished by grinding or polishing, which is a mechanical polishing method, or a chemical mechanical polishing (CMP) method, in which the polishing is performed through a chemical reaction using slurry.

The monocrystalline substrate 400, which is a final product, is prepared through the above-described surface processing (see (g) of FIG. 2).

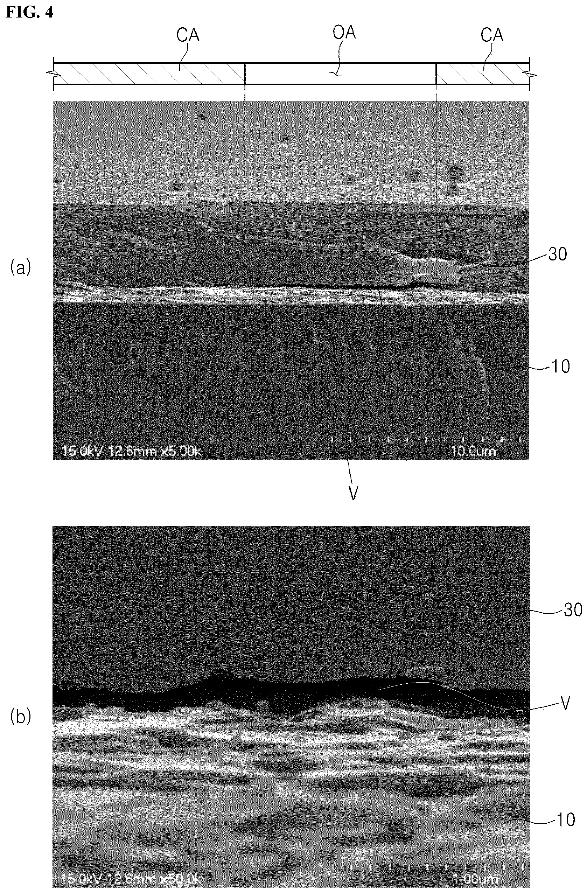

FIG. 4 is a photograph obtained by photographing a portion of a separation layer, in which a void is formed, through the method in accordance with an exemplary embodiment.

Hereinafter, a method of manufacturing a monocrystalline substrate according to an embodiment of the present invention will be collectively described with reference to FIGS. 2 and 4. Here, the contents duplicated with the previously described contents will be omitted or briefly described.

First, a seed layer 20 is formed on a base 10 as illustrated in (a) FIG. 2 (S110). For this, the base 10 is charged into a monocrystalline growth apparatus, and the seed layer 20 is formed on the base 10. Here, the base 10 may be a sapphire wafer, and the seed layer 20 may be a GaN layer formed to a thickness of approximately 2 µm to approximately 30 µm. Also, the seed layer 20 may be formed at a temperature of approximately 950°C to approximately 1,050°C.

Thereafter, laser is irradiated onto the seed layer 20 to form a separation layer 30 having a plurality of voids V. For this, first, the base 10 on which the seed layer 20 is formed is carried out of the monocrystalline growth apparatus. Then, as illustrated in (b) of FIG. 2, a mask M having a plurality of openings OA and closed portions CA is disposed under the base 10, and laser having a wavelength of approximately 362 nm or less, more particularly, solid laser having a wavelength of approximately 355 nm is irradiated from a lower side of the mask M.

The laser passes through a plurality of openings OA provided in a mask M and then passes through the base 10 and is irradiated onto the seed layer 20. The laser irradiated onto the seed layer 20 melts a portion of the seed layer 20. Here, since the laser is irradiated onto the seed layer 20 through the plurality of openings OA provided in the mask M, an area of the seed layer 20 facing the plurality of openings OA of the mask M may be melted. The plurality of voids V, which are empty spaces, are formed in the seed layer 20 as illustrated in (c) of FIG. 2 and FIG. 4. due to the melting. Also, it is seen that the void V is formed at a position facing or opposite to the opening OA of the mask M. The void V is formed in an interface between the base 10 within the seed layer 20 and the seed layer 20 or in an interface between the base 10 and the separation layer 30. In other words, the void V is formed to be adjacent to the base 10 compared to the monocrystalline layer 40 to be formed later on the separation layer 30.

When the separation layer 30 provided with the plurality of voids V is formed on the base 10, the base 10, on which the separation layer 30 is formed, is charged into the monocrystalline growth apparatus to form a monocrystalline layer 40 on the separation layer 30 as illustrated in (d) of FIG. 2 (S200). Here, the monocrystalline layer 40 may be a GaN layer formed to a thickness of approximately 400 µm to approximately 2,000 µm. Also, the monocrystalline layer 40 may be formed at a temperature of approximately 950°C to approximately 1,050°C.

Next, the base 10 on which the separation layer 30 and the monocrystalline layer 40 are formed is taken out from the monocrystalline growth apparatus and cooled at room temperature. Thus, stress is applied to the separation layer 30 by a difference in thermal expansion coefficient between the base 10 and the monocrystalline layer 40. Here, the stress acts in an arrangement direction of the base 10 and the monocrystalline layer 40. Thus, the separation layer 30 is separated to be divided in the arrangement direction of the base 10 and the monocrystalline layer 40, i.e., in a thickness direction. That is, based on the thickness direction of the separation layer 30, a lower portion adjacent to the base 10 is separated to be divided toward the base, and the remainder portion is separated to be divided toward the monocrystalline layer 40. Here, a portion of the separation layer 30 is separated to be divided toward the base 10, and the rest is separated to be divided toward the monocrystalline layer 40 on the area in which the voids V are formed, based on the thickness direction of the separation layer 30.

Also, when a predetermined impact is applied to the monocrystalline layer 40 or the base 10, the monocrystalline layer 40 may be completely separated from the base 10. Of course, the monocrystalline layer may be separated from the base only by cooling without applying an impact (see (e) of FIG. 2).

Next, as illustrated in (f) of FIG. 2, one surface of the monocrystalline layer 40, on which the separation layer 30 is laminated, is polished (S400) to remove the separation layer 30 from the monocrystalline layer 40. Here, it is more preferable to process not only one surface of the monocrystalline layer 40, but also the other surface, which is a surface opposite to the one surface. When the processing of the surface of the monocrystalline layer is completed in the above-described manner, the manufacturing of the monocrystalline substrate 400 is completed (see (g) of FIG. 2).

As described above, in accordance with the method of manufacturing the monocrystalline substrate 400 in accordance with an exemplary embodiment, a void V is formed in an interface between the base 10 and the seed layer 20. Thus, even if the void V is formed in the separation layer 30, the other surface of the separation layer 30, on which the monocrystalline layer 40 is grown, may be formed to be flat. Thus, the monocrystalline layer 40 is grown on the other surface of the flat separation layer 30 to prepare the monocrystalline substrate 400 having excellent crystallinity and suppressing an occurrence of defects. In addition, a process of planarizing the other surface of the separation layer 30 may be omitted, and a process time may be shortened.

Also, as the voids V are formed in the interface between the base 10 and the separation layer 30, the monocrystalline layer 40 may be more easily separated from the base 10 during the cooling after forming the monocrystalline layer 40. That is, when the separation layer 30 is divided by the stress applied by the cooling, if the voids V are formed in the interface between the base 10 and the separation layer 30, the separation layer 30 may be separated with relatively small stress when compared to when the voids are formed in a center in a thickness direction of the separation layer 30. Thus, the stress applied to the monocrystalline layer 40 may be reduced. Also, the separation layer 30 is divided with respect to the voids V, since the voids V are formed in the interface between the base 10 and the separation layer 30 so as to be disposed far from the monocrystalline layer 40, the stress applied to the monocrystalline layer 40 during the separation may be suppressed or minimized. Therefore, the stress applied to the monocrystalline layer 40 may be reduced, and the occurrence of the defects such as the cracks and the breakage in the monocrystalline layer 40 due to the stress may be suppressed or prevented.

In accordance with the method for manufacturing the monocrystalline substrate in accordance with the exemplary embodiment, the laser may be irradiated onto the seed layer from the lower side of the base to form the void in the interface between the base and the separation layer. As a result, even if the voids are formed in the separation layer, the surface of the separation layer, on which the monocrystalline layer is grown, may be formed to be flat.

Therefore, the monocrystalline layer may be grown on the flat surface of the separation layer, and the monocrystalline substrate having the excellent crystallinity and suppressed in occurrence of the defects may be prepared. That is, the monocrystalline substrate having the excellent crystallinity and suppressed in occurrence of the defects while omitting the planarization process for planarizing the surface of the flat separation layer may be prepared.

Also, since the void is formed in the interface between the base and the separation layer so as to be disposed away from the monocrystalline layer, the stress applied to the monocrystalline layer during the separation may be suppressed or minimized. Therefore, the stress applied to the monocrystalline layer may be reduced to suppress or prevent the occurrence of the defects in the monocrystalline layer due to the stress.

Although the method for manufacturing the monocrystalline substrate has been described with reference to the specific embodiments, it is not limited thereto. Therefore, it will be readily understood by those skilled in the art that various modifications and changes can be made thereto without departing from the spirit and scope of the present invention defined by the appended claims.

## Claims

1. A method for manufacturing a monocrystalline substrate, the method comprising:
a process of forming a seed layer on a base charged into a monocrystalline growth apparatus;
a process of taking the base, on which the seed layer is formed, out of the monocrystalline growth apparatus and irradiating laser onto the seed layer from a lower side of the base to form a separation layer having a plurality of voids;
a process of charging the base, on which the separation layer is formed, into the monocrystalline growth apparatus to form a monocrystalline layer on the separation layer; and
a separation process of taking the base, on which the separation layer and the monocrystalline layer are formed, out of the monocrystalline growth apparatus to separate the monocrystalline layer from the base.

2. The method of claim 1, wherein, in the process of forming the separation layer, the voids are formed in an interface between the base and the separation layer.

3. The method of claim 1 or 2, wherein the process of irradiating the laser onto the seed layer from the lower side of the base comprises a process of discontinuously irradiating the laser in an extension direction of the seed layer.

4. The method of any of the claims 1 to 3, wherein the process of discontinuously irradiating the laser in the extension direction of the seed layer comprises:
a process of preparing a mask, in which a plurality of opening and closed portions are alternately disposed;
a process of disposing the mask to face the base at an opposite side of the seed layer; and
a process of emitting the laser to pass through the mask and the base.

5. The method of o any of the claims 1 to 4, wherein, in the process of preparing the mask, a ratio of a length of each of the openings to a length of each of the closed portions is 2:1 to 1:5.

6. The method of any of the claims 1 to 5, wherein, in the process of preparing the mask, the opening has a length of approximately 1 *µ*m to approximately 100 *µ*m.

7. The method of any of the claims 1 to 6, wherein the process of discontinuously irradiating the laser in the extension direction of the seed layer comprises:
a process of horizontally moving the base, on which the seed layer is formed; and
a process of irradiating the laser onto the base from an opposite side of the seed layer formed on the base which moves horizontally and alternately repeatedly performing an stopping operation of the irradiation.

8. The method of any of the claims 1 to 7, wherein the separation process comprises a process of dividing the separation layer in a lamination direction of the base and the monocrystalline layer.

9. The method of any one of claims 1 to 8, wherein each of the seed layer and the monocrystalline layer comprises a GaN layer.

10. The method of any of the claims 1 to 9, wherein, in the process of forming the seed layer, the seed layer is formed to a thickness of approximately 2 *µ*m to approximately 30 *µ*m.
